# EUROPÄISCHE PATENTSCHRIFT

(11) **EP 2 945 240 B1**
(45) Veröffentlichungstag und Bekanntmachung des Hinweises auf die Patenterteilung: **26.02.2020**
(21) Anmeldenummer: 15167563.4
(22) Anmeldetag: 13.05.2015
(51) Int. Cl.: H02H 5/10, H02H 3/14

(54) **STROMVERTEILERVORRICHTUNG MIT SCHUTZLEITERÜBERWACHUNGSEINRICHTUNG UND VERFAHREN**
CURRENT DISTRIBUTOR DEVICE WITH PROTECTION CONDUCTOR MONITORING DEVICE AND METHOD
DISPOSITIF DE RÉPARTITION DE L'ALIMENTATION, DISPOSITIF DE SURVEILLANCE DE CONDUCTEUR DE MISE À LA TERRE ET PROCÉDÉ

(30) Priorität: 13.05.2014 DE 102014006849; 02.03.2015 DE 102015002554
(43) Veröffentlichungstag der Anmeldung: 18.11.2015
(73) Patentinhaber: Brandes, Peter, 31241 Ilsede (DE)
(72) Erfinder: Brandes, Peter, 31241 Ilsede (DE)
(74) Vertreter: Patentanwälte Magenbauer & Kollegen Partnerschaft mbB

(56) Entgegenhaltungen:
- WO-A1-95/31028
- DE-U1- 29 519 212
- GB-A- 2 167 618

## Beschreibung

Die Erfindung betrifft eine Stromverteilervorrichtung, die ortsfest oder ortsveränderlich ausgebildet ist, insbesondere eine Steckdose, Steckdosenleiste, Steckadapter, Leitungsroller, Baustromverteiler, Anschlussleitung oder Verlängerungsleitung, und die dazu dient, einem oder mehreren elektrischen Verbrauchern eine Netzspannung bereitzustellen, die von einer mit einem Schutzleiter ausgestatteten elektrischen Leitung zugeführt wird, mit einer Schutzleiterüberwachungseinrichtung zur Erkennung einer Schutzleiterstörung auf der elektrischen Leitung, wobei die Schutzleiterüberwachungseinrichtung einen ersten Anschlusspunkt umfasst, der mit dem Schutzleiter elektrisch verbindbar oder verbunden ist.

Die Erfindung betrifft ferner ein Schutzleiterüberwachungsverfahren zur Erkennung einer Schutzleiterstörung auf einer mit einem Schutzleiter ausgestatteten elektrischen Leitung. Unter einer Stromverteilervorrichtung ist im Allgemeinen eine Vorrichtung zu verstehen, die dazu dient, einem elektrischen Verbraucher Netzspannung zuzuführen und die dafür mit mindestens einem Phasenleiter, einem Neutralleiter und einem Schutzleiter einer elektrischen Leitung, wie z.B. einer Netzleitung eines Verteilers, verbunden werden kann oder verbunden ist. Eine solche Stromverteilervorrichtung dient ferner dazu, einen elektrischen Kontakt zwischen einem Schutzleiteranschluss eines elektrischen Verbrauchers und dem Schutzleiter einer elektrischen Leitung herzustellen. Eine Stromverteilervorrichtung kann ortsfest ausgebildet sein; d.h. eine Stromverteilervorrichtung kann ausgebildet sein, im Betrieb z.B. fest mit einer Gebäudeinstallation verbunden zu sein. Beispielsweise kann eine Stromverteilervorrichtung als Steckdose bzw. Steckdoseninstallation oder als Vorrichtung in Hutschienenbauweise ausgebildet sein. Alternativ kann eine Stromverteilervorrichtung auch ortsveränderlich ausgebildet sein und beispielsweise einen Stecker aufweisen, so dass sie je nach Bedarf an verschiedenen Orten eingesetzt werden kann und mit Anschlüssen verschiedener elektrischer Leitungen lösbar verbunden werden kann. Beispielsweise kann eine Stromverteilervorrichtung als Steckdosenleiste, Steckadapter, Leitungsroller, Baustromverteiler, Anschlussleitung oder Verlängerungsleitung ausgebildet sein.

Bei elektrischen Leitungen kann es grundsätzlich vorkommen, dass eine Schutzleiterstörung vorliegt. Insbesondere kann es vorkommen, dass die elektrische Verbindung zur Erdung des Schutzleiters unterbrochen ist oder einen erhöhten ohmschen Widerstand aufweist. In diesen Fällen kann der von dem Schutzleiter zu erbringende Schutz nicht gewährleistet werden.

Es ist daher wünschenswert, eine solche Schutzleiterstörung zu erkennen, damit ein entsprechendes Warnsignal ausgegeben werden kann.

Aus der EP 2 626 965 A1 ist eine Stromleitungsverlängerung mit einer Prüfeinheit bekannt, die dazu dient, eine Unterbrechung des Schutzleiters zu erkennen und ein Warnsignal auszugeben. Zu diesem Zweck wird ein Strom über eine Basis-Emitter-Strecke eines Transistors auf den Schutzleiter gegeben. Wenn es zu einer Unterbrechung auf dem Schutzleiter kommt, kann der Strom nicht mehr fließen und der Transistor sperrt seine Kollektor-Emitter-Strecke. Dies wiederrum löst die Ausgabe eines entsprechenden Warnsignals aus.

Aus der EP 0 806 825 B1 ist ein DI-Fehlerstromschutzschalter mit einer Einrichtung zur Erkennung eines Schutzleiterzustandes bekannt. Um den Zustand eines nicht angeschlossenen oder unterbrochenen Schutzleiters zu erkennen, ist eine Schaltung vorgesehen, bei welcher ein Strom über mehrere Schutzimpedanzen und eine Leuchtdiode von einem L- oder N-Leiter zu dem Schutzleiter geleitet wird. Ein lichtempfindlicher Transistor empfängt das von der Leuchtdiode ausgestrahlte Licht und wird abhängig davon leitend. Wenn der lichtempfindliche Transistor nicht leitend ist, wird dies über einen IC als fehlerhafter Zustand erkannt.

Bei den aus dem Stand der Technik bekannten Überwachungsvorrichtungen ist es schwierig, genau einzustellen, ab welchem Widerstand auf dem Schutzleiter eine Schutzleiterstörung festgestellt werden soll. Insbesondere hängt bei den bekannten Überwachungsvorrichtungen der Widerstandswert, ab dem die Schutzleiterstörung festgestellt wird, von intrinsischen Eigenschaften der verwendeten Halbleiterbauelemente - wie z.B. einem Bipolartransistor, einer Leuchtdiode oder einem lichtempfindlichen Transistors ab. Die intrinsischen Eigenschaften dieser Bauelemente sind meist temperaturabhängig und unterliegen zudem Prozessschwankungen. Sie sind somit nicht dazu geeignet, einen genauen Schwellenwert zu definieren. Als Konsequenz kann bei den aus dem Stand der Technik bekannten Schaltungen keine niederohmige Schutzleiterstörung erkannt werden.

Die WO 95/31028 beschreibt einen Detektor zur Überwachung der Integrität einer Erdungs-Verbindung zu einem Elektrogerät. Der Detektor umfasst eine Differenzkomparatorschaltung zum Vergleich einer Spannung an einer N-Leiter-Verbindung mit einer Spannung an einem Erdungsanschluss des Geräts und zur Erzeugung eines Fehlersignals, falls eine Differenz dazwischen einen vorbestimmten Schwellenwert überschreitet. Der Detektor umfasst einen Brückengleichrichter. Zur Erzeugung der von der Differenzkomparatorschaltung zu vergleichenden Spannungen umfasst der Detektor einen ersten und einen zweiten Spannungsteiler.Die DE 295 19 212 U1 beschreibt eine Schaltungsanordnung zur Erdungsüberwachung. Die Schaltungsanordnung umfasst zwei Kondensatoren, die zwischen einem Schutzleiter und einem Nullleiter sowie zwischen dem Schutzleiter und einem Phasenleiter angeordnet sind. Die Schaltungsanordnung umfasst ferner ein Überwachungsglied, das vom Schutzleiter angesteuert wird und bei Überschreitung eines vorgebbaren Schwellwerts ein Alarmsignal auslöst.

Die GB 2 167 618 A beschreibt eine elektrische Schutzschaltung mit einer Halbleiterschaltung zum periodischen Abtasten eines Stromflusses zwischen einem L-Leiter einer Netzversorgung und einer lokalen Netzerdung und zum Bereitstellen eines Ausgabesignals, das den Stromfluss anzeigt. Die elektrische Schutzschaltung umfasst ferner Mittel zum Bestimmen des Werts des Ausgabesignals um den Wert der Erdungsimpedanz zu bestimmen und Schaltungsunterbrechungsmittel zur Unterbrechung der Leistungsversorgung, falls die Erdungsimpedanz zu hoch ist.

Es ist eine Aufgabe der Erfindung, eine verbesserte Stromverteilervorrichtung bereitzustellen. Insbesondere ist es eine Aufgabe der Erfindung, eine Stromverteilervorrichtung mit einer Schutzleiterüberwachungseinrichtung bereitzustellen, bei welcher der Widerstandswert auf dem Schutzleiter, ab dem eine Schutzleiterstörung erkannt wird, hinreichend genau definiert werden kann, so dass die Erkennung einer Schutzleiterstörung im niederohmigen Bereich möglich wird.

Die Aufgabe wird für eine Stromverteilervorrichtung der eingangs genannten Art mit den Merkmalen des Anspruchs 1 gelöst. Die erfindungsgemäße Stromverteilervorrichtung umfasst eine Schutzleiterüberwachungseinrichtung mit: einer ersten Schaltungsanordnung die ausgebildet ist, in einem Zustand, in dem der erste Anschlusspunkt mit dem Schutzleiter verbunden ist, eine elektrische Messgröße bereitzustellen, die von dem Widerstand zwischen dem ersten Anschlusspunkt und der Erdung des Schutzleiters abhängt, einer zweiten Schaltungsanordnung die ausgebildet ist, eine elektrische Vergleichsgröße bereitzustellen, und einer einen Komparator aufweisenden Komparatoranordnung die ausgebildet ist, die elektrische Messgröße mit der elektrischen Vergleichsgröße zu vergleichen und gemäß dem Vergleichsergebnis ein Erkennungssignal zur Erkennung einer Schutzleiterstörung bereitzustellen.

Erfindungsgemäß werden also zwei elektrische Größen - nämlich die elektrische Messgröße und die elektrische Vergleichsgröße - bereitgestellt und mittels eines Komparators miteinander verglichen. Die zwei elektrischen Größen sind z.B. Potentiale, Spannungen oder Ströme, die von den Schaltungsanordnungen bereitgestellt bzw. generiert werden. Die bereitgestellte elektrische Messgröße hängt dabei von dem Widerstand zwischen dem Anschlusspunkt und der Erdung des Schutzleiters ab. Insbesondere bildet die elektrische Messgröße diesen Widerstand ab. Das heißt, die elektrische Messgröße verhält sich in Entsprechung zu dem Widerstand. Überschreitet bzw. unterschreitet die bereitgestellte elektrische Messgröße die elektrische Vergleichsgröße, so deutet dies darauf hin, dass der Widerstand auf dem Schutzleiter größer als ein bestimmter Schwellenwert ist, und dass somit eine Schutzleiterstörung vorliegen kann.

Der Schwellenwert für den Widerstand auf dem Schutzleiter, ab dem eine Schutzleiterstörung erkannt wird, kann somit über eine entsprechende Einstellung der elektrischen Vergleichsgröße genau definiert werden. Eine solche genaue Einstellung der elektrischen Vergleichsgröße - also eine Bereitstellung eines entsprechenden Vergleichsstroms oder Vergleichspotentials - ist schaltungstechnisch präziser zu realisieren als die im diskutierten Stand der Technik zur Definition des Schwellenwerts notwendige Einstellung intrinsischer Eigenschaften von Halbleiterbauelementen. Beispielsweise kann ein entsprechendes Vergleichspotential in präziser Weise mittels eines Spannungsteilers bereitgestellt bzw. generiert werden, für den lediglich wenigstens zwei Widerstände benötigt werden.

Folglich kann bei der vorliegenden Erfindung der Widerstandswert auf dem Schutzleiter, ab dem eine Schutzleiterstörung erkannt wird, hinreichend genau definiert werden, so dass die Erkennung einer Schutzleiterstörung im niederohmigen Bereich möglich wird.

Die elektrische Messgröße bildet den Widerstand von dem Anschlusspunkt zu der Erdung des Schutzleiters ab. Das heißt, dass ein direkter Zusammenhang besteht zwischen der elektrischen Messgröße und dem Widerstand von dem Anschlusspunkt zu der Erdung des Schutzleiters. Insbesondere handelt es sich hierbei zumindest im Arbeitsbereich der Komparatoranordnung um einen streng monotonen Zusammenhang, so dass eine Erhöhung bzw. Erniedrigung des Widerstands zwischen dem ersten Anschlusspunkt und der Erdung des Schutzleiters zu einer Erhöhung bzw. Erniedrigung der elektrischen Messgröße führt. Eine Schaltungsanordnung, die eine solche elektrische Messgröße bereitstellt bzw. generiert, kann, wie bereits erwähnt, sehr einfach mittels eines Spannungsteilers realisiert werden, der zwischen den ersten Anschlusspunkt und einer Spannungsquelle geschaltet wird, so dass ein von dem Spannungsteiler als die elektrische Messgröße bereitgestelltes bzw. generiertes Messpotential den Widerstand zwischen dem ersten Anschlusspunkt und der Erdung des Schutzleiters abbildet.

Die elektrische Messgröße ist ein Messpotential und die elektrische Vergleichsgröße ist ein Vergleichspotential.

Wie bereits vorstehend erwähnt, können ein entsprechendes Messpotential und ein entsprechendes Vergleichspotential in einfacher Weise mittels entsprechender Spannungsteiler bereitgestellt werden. Insbesondere kann über einen entsprechenden Spannungsteiler ein gewünschtes Vergleichspotential sehr genau eingestellt werden. Vorzugsweise wird eine Schutzleiterstörung erkannt, wenn das Messpotential für mindestens eine vorbestimmte Zeitdauer über dem Vergleichspotential liegt.

In weiterer Ausgestaltung der Erfindung ist vorgesehen, dass der Komparator einen Differenzverstärker umfasst und die erste Schaltungsanordnung und die zweite Schaltungsanordnung ausgebildet sind, das Messpotential und das Vergleichspotential den Eingängen des Differenzverstärkers zuzuführen.

In bevorzugter Weise wird somit ein Differenzverstärker als Komparator verwendet. Der Differenzverstärker kann z.B. zwei gleichartige Transistoren mit einem gemeinsamen Emitterwiderstand umfassen. Der Differenzverstärker kann ferner zwei Lastwiderstände oder einen Stromspiegel umfassen. Vorzugsweise sind die Transistoren Bipolartransistoren. Insbesondere sind die Transistoren als Hochvolttransistoren ausgebildet. Die Transistoren sind vorzugsweise als PNP-Transistoren ausgebildet; sie können alternativ aber auch als NPN-Transistoren ausgebildet sein.

Durch die Verwendung eines Differenzverstärkers wird die Erkennung der Schutzleiterstörung über einen differentiellen Vergleich zweier Eingangsspannungen erzielt. Gegenüber der aus dem Stand der Technik bekannten Schaltung hat dies den Vorteil, dass Störgrößen, wie z.B. Temperatur- oder Prozessschwankungen, unterdrückt werden können.

Die Schutzleiterüberwachungsvorrichtung umfasst ferner einen zweiten Anschlusspunkt, der mit einem Phasenleiter der elektrischen Leitung elektrisch verbindbar oder verbunden ist, einen dritten Anschlusspunkt, der mit einem Neutralleiter der elektrischen Leitung elektrisch verbindbar oder verbunden ist, und eine vorzugsweise mit einer Gleichrichterbrücke ausgestattete Gleichrichteranordnung, die ausgebildet ist, eine zwischen dem zweiten Anschlusspunkt und dem dritten Anschlusspunkt anliegende Wechselspannung in eine gleichgerichtete Spannung zu wandeln und diese der Komparatoranordnung über den Ausgang der Gleichrichteranordnung als Versorgungsspannung zuzuführen.

In bevorzugter Weise wird die zwischen dem Phasenleiter und dem Neutralleiter anliegende Wechselspannung bzw. Netzspannung gleichgerichtet. Die Komparatoranordnung bzw. der Komparator/der Differenzverstärker wird vorzugsweise direkt aus dieser gleichgerichteten Spannung oder über einen Vorwiderstand gespeist. Die gleichgerichtete Spannung kann dabei die Form einer pulsierenden Gleichspannung haben.

Eine solche Speisung der Komparatoranordnung aus der gleichgerichteten Spannung ist vorteilhaft, da dadurch für die Komparatoranordnung keine eigene Spannungsquelle erforderlich ist. Ferner ist auch kein Glättungskondensator zwischen den Ausgangsanschlüssen der Gleichrichteranordnung erforderlich, da die Komparatoranordnung auch mit einer pulsierenden Spannung als Versorgungsspannung funktioniert.

Die Gleichrichteranordnung umfasst vorzugsweise vier als Gleichrichterbrücke geschaltete Dioden. Die Gleichrichteranordnung kann ferner einen oder mehrere Widerstände zur Strombegrenzung und/oder einen Varistor zur Spannungsbegrenzung umfassen.

Die Verwendung einer Gleichrichterbrücke ist von Vorteil, da es dabei für die Funktionalität der Schutzleiterüberwachungsvorrichtung keine Rolle spielt, mit welcher Polarität der Phasenleiter und der Neutralleiter an den zweiten und den dritten Anschlusspunkt angeschlossen werden. Insbesondere funktioniert die beschriebene Schutzleiterüberwachungsvorrichtung selbst dann, wenn der Phasenleiter und der Neutralleiter vertauscht werden - also wenn der Phasenleiter an den dritten Anschlusspunkt und der Neutralleiter an den zweiten Anschlusspunkt angeschlossen wird. Dies ist insbesondere von Vorteil bei ortsveränderlichen Stromverteilervorrichtungen, da bei diesen in der Regel nicht festgelegt ist, mit welcher Polarität eine elektrische Leitung anzuschließen ist.

Die erste Schaltungsanordnung ist ausgebildet, das Messpotential von einer Spannung abzuleiten, die zwischen einem Ausgangsanschluss der Gleichrichteranordnung und einem mit dem ersten Anschlusspunkt elektrisch verbundenen Knoten anliegt, und das Messpotential der Komparatoranordnung bereitzustellen.

In bevorzugter Weise kann das Messpotential folglich direkt aus einem an einem Ausgangsanschluss der Gleichrichteranordnung anliegenden Potential generiert bzw. bereitgestellt werden. Insbesondere wird das Messpotential dabei von dem positiven bzw. oberen Anschluss des Ausgangs der Gleichrichteranordnung abgeleitet.

In diesem Zusammenhang sei erwähnt, dass es sich bei dem Messpotential nicht unbedingt um ein festes Potential handelt. Insbesondere dann, wenn die Gleichrichteranordnung eine pulsierende Gleichspannung ausgibt, wird natürlich auch das basierend auf dem Ausgang der Gleichrichteranordnung generierte Messpotential eine pulsierende Charakteristik aufweisen.

Der mit dem ersten Anschlusspunkt elektrisch verbundene Knoten kann vorzugsweise direkt oder über eine Kollektor-Emitter-Strecke eines Transistors mit dem ersten Anschlusspunkt elektrisch verbunden sein.

In weiterer Ausgestaltung der Erfindung ist vorgesehen, dass die erste Schaltungsanordnung einen ersten Spannungsteiler mit vorzugsweise wenigstens zwei Widerständen umfasst, wobei der erste Spannungsteiler zwischen dem Ausgangsanschluss der Gleichrichteranordnung und dem mit dem ersten Anschlusspunkt elektrisch verbundenen Knoten geschaltet ist und ausgebildet ist, die über dem ersten Spannungsteiler anliegende Spannung in einem ersten vorbestimmten Verhältnis aufzuteilen und das resultierende Potential der Komparatoranordnung als das Messpotential bereitzustellen.

Das von dem Spannungsteiler bereitgestellte Messpotential hängt von dem Potential des ersten Anschlusspunktes ab. Dieses wiederum ist abhängig von dem Widerstand zwischen dem ersten Anschlusspunkt und der Erdung des Schutzleiters. Somit kann in der beschriebenen Weise ein Messpotential bereitgestellt werden, dass sich gemäß dem Widerstand zwischen dem ersten Anschlusspunkt und der Erdung des Schutzleiters verhält bzw. diesen Widerstand abbildet.

Die zweite Schaltungsanordnung ist ausgebildet, das Vergleichspotential von der gleichgerichteten Spannung abzuleiten und der Komparatoranordnung bereitzustellen.

Dabei wird das Vergleichspotential von der Spannung abgeleitet, die zwischen den beiden Ausgangsanschlüssen der Gleichrichteranordnung anliegt. Wie bei dem Messpotential muss auch hier beachtet werden, dass es sich bei dem Vergleichspotential nicht zwingend um ein festes Potential handeln muss, sondern dass auch das Vergleichspotential eine pulsierende Charakteristik aufweisen kann. Für den Vergleich mit dem Messpotential stellt dies kein Problem dar, da, wie vorstehend beschrieben, auch das Messpotential eine pulsierende Charakteristik aufweisen kann, und diese beim Vergleich mittels des Komparators als Gleichtaktkomponente wirksam unterdrückt werden kann.

In weiterer Ausgestaltung der Erfindung ist vorgesehen, dass die zweite Schaltungsanordnung einen zweiten Spannungsteiler mit vorzugsweise wenigstens zwei Widerständen umfasst, wobei der zweite Spannungsteiler zwischen beiden Ausgangsanschlüssen der Gleichrichteranordnung geschaltet ist und ausgebildet ist, die gleichgerichtete Spannung in einem zweiten vorbestimmten Verhältnis aufzuteilen und das resultierende Potential der Komparatoranordnung als das Vergleichspotential bereitzustellen.

In weiterer Ausgestaltung der Erfindung ist vorgesehen, dass die Komparatoranordnung ferner ein Speicherglied vorzugsweise ein Tiefpassglied, umfasst, der Komparator ausgebildet ist, das Messpotential mit dem Vergleichspotential zu vergleichen und gemäß dem Vergleichsergebnis ein Komparatorsignal auszugeben, die Komparatoranordnung ausgebildet ist, das Speicherglied gemäß dem Komparatorsignal aufzuladen oder zu entladen, und das Erkennungssignal gemäß dem Ladezustand des Speicherglieds bereitzustellen, wobei das Speicherglied vorzugsweise einen Kondensator umfasst und das Erkennungssignal vorzugsweise von der über dem Kondensator abfallenden Spannung abhängt.

In besonders bevorzugter Weise dient also nicht direkt der Ausgang des Komparators als das Erkennungssignal, sondern stattdessen der Ladezustand eines gemäß dem Ausgang des Komparators aufgeladenen oder entladenen Speicherglieds. Dies ist darin begründet, dass bei dem oben beschriebenen Ansatz, wonach das Messpotential und das Vergleichspotential von dem Ausgang der Gleichrichteranordnung abgeleitet werden, der Ausgang des Komparators auch dann zeitweise kippen kann, wenn keine Schutzleiterstörung vorliegt. Durch die Verwendung des Speicherglieds bewirkt dieses zeitweise Kippen lediglich ein kurzen Aufladen oder Entladen des Speicherglieds und beeinflusst deshalb den Ladezustand des Speicherglieds nicht wesentlich. Nimmt man also den Ladezustand des Speicherglieds als das Erkennungssignal, so ist das zeitweise Kippen gewissermaßen herausgefiltert. Das Speicherglied umfasst dabei vorzugsweise einen Kondensator, der in der Art eines RC-Glieds bzw. Tiefpasses über einen Widerstand aufgeladen und/oder entladen wird. Ferner umfasst das Speicherglied vorzugsweise einen Transistor, dessen Eingang mit dem Ausgang des Komparators verbunden ist, und der in Abhängigkeit von dem Komparatorsignal ein Aufladen und/oder Entladen des Kondensators bewirkt.

In weiterer Ausgestaltung der Erfindung ist vorgesehen, dass die Schutzleiterüberwachungseinrichtung ferner umfasst: wenigstens ein vorzugsweise eine LED und/oder einen Lautsprecher aufweisendes Signalglied, das ausgebildet ist, bei Betätigung ein elektrisches, optisches und/oder akustisches Signal zur Anzeige einer Schutzleiterstörung auszugeben, und ein erstes Schaltglied, das ausgebildet ist, das Signalglied zu betätigen, falls das Erkennungssignal einen vorbestimmten Schwellenwert überschreitet oder unterschreitet.

In weiterer Ausgestaltung der Erfindung ist vorgesehen, dass die Schutzleiterüberwachungseinrichtung ferner umfasst: ein vorzugsweise ein Relais aufweisendes zweites Schaltglied zur Ansteuerung eines RCD, das ausgebildet ist, bei Betätigung zu bewirken, dass eine elektrische Verbindung zwischen dem einen oder mehreren elektrischen Verbrauchern und dem Phasenleiter dem Neutralleiter und/oder dem Schutzleiter getrennt wird, und ein erstes Schaltglied das ausgebildet ist, das zweite Schaltglied zu betätigen, falls das Erkennungssignal einen vorbestimmten Schwellenwert überschreitet oder unterschreitet.

In weiterer Ausgestaltung der Erfindung ist vorgesehen, dass die Schutzleiterüberwachungseinrichtung ferner umfasst: ein vorzugsweise mit einem Transistor ausgestattetes Entkopplungsglied das ausgebildet ist, bei Betätigung die elektrische Verbindung zwischen der ersten Schaltungsanordnung und dem ersten Anschlusspunkt hochohmig zu schalten, und ein erstes Schaltglied das ausgebildet ist, das Entkopplungsglied zu betätigen, falls das Erkennungssignal einen vorbestimmten Schwellenwert überschreitet oder unterschreitet.

Das Entkopplungsglied dient insbesondere dazu, hochohmige Einkopplungen der Phase in den Schutzleiter zu verhindern, falls der erste Anschlusspunkt nicht auf dem Erdungspotential liegt.

In weiterer Ausgestaltung der Erfindung ist vorgesehen, dass die Schutzleiterüberwachungseinrichtung ferner umfasst: ein Phasenüberwachungsmodul, das ausgebildet ist, vorzugsweise anhand einer kapazitiven Phasenfelderkennung, zu detektieren, dass der Schutzleiter eine Wechselspannung führt, und in diesem Fall zu bewirken, dass eine elektrische Verbindung zwischen einem elektrischen Verbraucher und dem Phasenleiter dem Neutralleiter und/oder dem Schutzleiter getrennt wird.

In dieser Weise kann die Stromverteilervorrichtung eine PRCD-S Funktionalität bereitstellen.

In weiterer Ausgestaltung der Erfindung ist vorgesehen, dass die Stromverteilervorrichtung einen Netzstecker umfasst und der erste Anschlusspunkt der zweite Anschlusspunkt und der dritte Anschlusspunkt mit jeweiligen Kontakten des Netzsteckers elektrisch verbunden sind.

Die oben genannte Aufgabe wird ferner für ein Schutzleiterüberwachungsverfahren der eingangs erwähnten Art mit den Merkmalen des Anspruchs 11 gelöst. Für das erfindungsgemäße Verfahren wird die vorstehend beschriebene Stromverteilervorrichtung eingesetzt.

Vorteilhafte Ausführungsformen der Erfindung sind in der Zeichnung dargestellt. Dabei zeigt
- Figur 1: ein schematisches Blockschaltbild einer Schutzleiterüberwachungseinrichtung einer Stromverteilervorrichtung,
- Figur 2: ein Schaltbild einer Schutzleiterüberwachungseinrichtung einer Stromverteilervorrichtung,
- Figur 3: ein Schaltbild einer weiteren Schutzleiterüberwachungseinrichtung einer Stromverteilervorrichtung,
- Figur 4: ein Schaltbild einer weiteren Schutzleiterüberwachungseinrichtung einer Stromverteilervorrichtung,
- Figur 5: eine schematische Darstellung einer Stromverteilervorrichtung.

In der nachstehenden Figurenbeschreibung werden für funktionsgleiche Komponenten der dargestellten Ausführungsformen jeweils gleiche Bezeichnungen verwendet, wobei auf eine mehrfache Beschreibung funktionsgleicher Komponenten verzichtet wird.

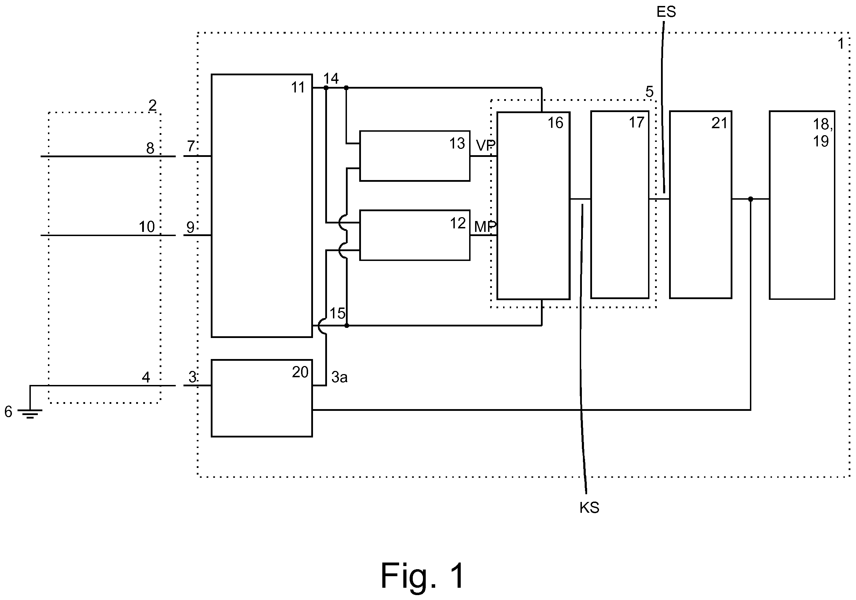

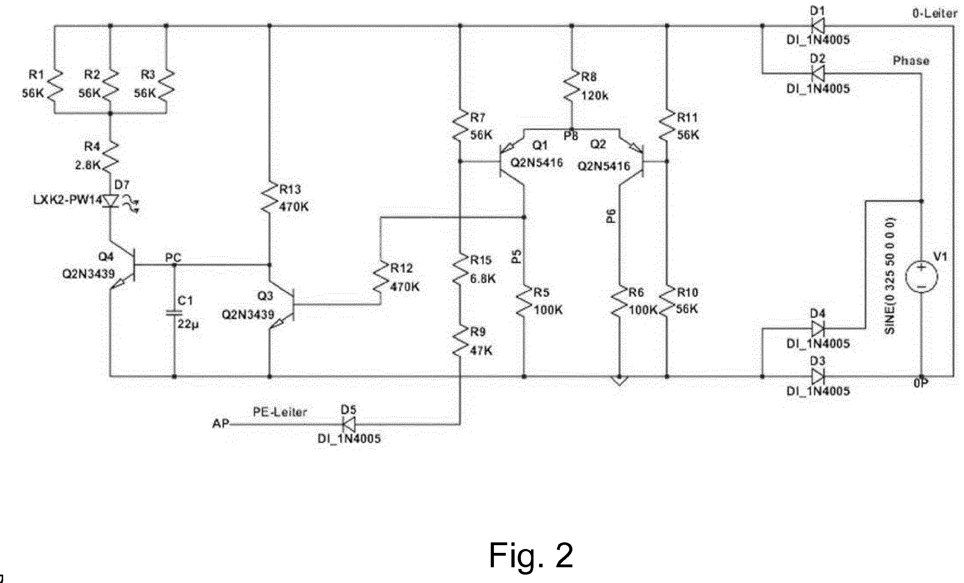

Die Figur 1 zeigt ein schematisches Blockschaltbild einer Schutzleiterüberwachungseinrichtung 1 einer Stromverteilervorrichtung. Die Figuren 2, 3 und 4 zeigen jeweils konkrete Schaltungen, die als die Schutzleiterüberwachungseinrichtung 1 eingesetzt werden können.

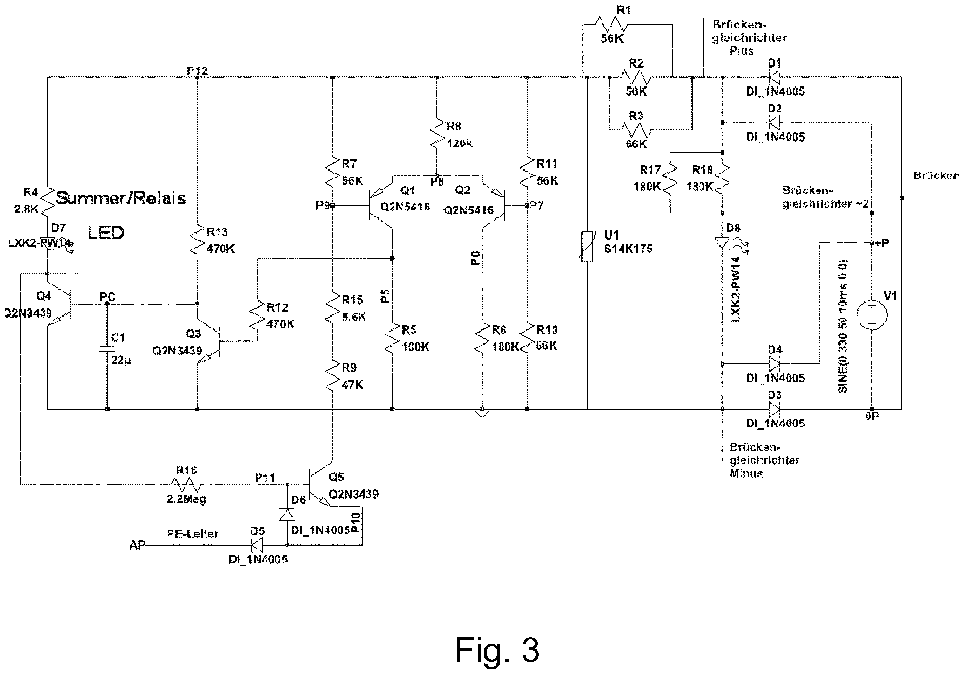

Die in den Figuren 2 und 3 angegebenen konkreten Typenbezeichnungen und Werte für die einzelnen Bauelemente sind rein exemplarisch zu verstehen. Die gezeigten Schaltungen sind nicht auf diese exemplarisch angegebenen Typen und Werte beschränkt. Ferner ist die in den Figuren 2 und 3 gezeigte Spannungsquelle V1 nicht zwingend Teil der beschriebenen Schutzleiterüberwachungseinrichtung 1. Stattdessen kann die Spannungsquelle V1 für die zwischen dem Phasenleiter 8 und dem Neutralleiter 10 der elektrischen Leitung 2 anliegenden Wechselspannung bzw. Netzspannung stehen.

Wie eingangs erwähnt, dient die Stromverteilervorrichtung dazu, einen oder mehrere elektrische Verbraucher mit einer Netzspannung zu versorgen, und einen elektrischen Kontakt zwischen dem/den elektrischen Verbrauchern und einem Schutzleiter herzustellen. In bevorzugter Weise dient die Stromverteilervorrichtung ferner dazu, eine Schutzleiterstörung zu erkennen.

Zu diesem Zweck umfasst die erfindungsgemäße Stromverteilervorrichtung eine Schutzleiterüberwachungseinrichtung 1. Ein Beispiel für eine Schutzleiterüberwachungseinrichtung 1 ist in der Figur 1 gezeigt. Wie der Figur 1 entnommen werden kann, umfasst die Schutzleiterüberwachungseinrichtung 1 insbesondere eine Gleichrichteranordnung 11, eine erste Schaltungsanordnung 12 und eine zweite Schaltungsanordnung 13. Die Gleichrichteranordnung 11 weist als Eingang einen zweiten Anschlusspunkt 7 und einen dritten Anschlusspunkt 9 auf. Diese Anschlusspunkte sind mit einem Phasenleiter 8 und einem Neutralleiter 10 einer elektrischen Leitung 2 verbunden oder verbindbar. Im verbundenen Zustand liegt am Eingang der Gleichrichteranordnung 11 eine Wechselspannung an, die von der Gleichrichteranordnung 11 in eine gleichgerichtete Spannung gewandelt wird, die zwischen den beiden Ausgangsanschlüssen 14 und 15 der Gleichrichteranordnung 11 ausgegeben wird.

Die Figuren 2, 3 und 4 zeigen konkrete Schaltungsbeispiele der Schutzüberwachungseinrichtung 1. In den gezeigten Schaltungsbeispielen umfasst die Gleichrichteranordnung 11 eine aus den Dioden D1, D2, D3 und D4 gebildete Gleichrichterbrücke. In dem Beispiel der Figur 3 umfasst die Gleichrichteranordnung 11 zudem die der Strombegrenzung dienenden Widerstände R1, R2 und R3, sowie den Varistor U1, der die zwischen den Ausgangsanschlüssen 14 und 15 abfallende Spannung auf einen Maximalwert begrenzt. Es sei in diesem Zusammenhang angemerkt, dass die Widerstände R1, R2 und R3, und der Varistor U1 optionale Merkmale darstellen, die zur Lösung der Aufgabe nicht zwingend erforderlich sind.

In den Schaltungsbeispielen der Figuren 2, 3 und 4 sind die Schaltungsanordnungen 12 und 13 als Spannungsteiler ausgebildet. Die erste Schaltungsanordnung 12 umfasst die Widerstände R7, R15 und optional R9 und stellt an dem Knoten P9 das Messpotential MP bereit, während die zweite Schaltungsanordnung die Widerstände R11 und R10 umfasst und an dem Knoten P7 das Vergleichspotential VP bereitstellt. Die Widerstandswerte R7, R15, R9, R11 und R10 sind so gewählt, dass ein genauer Schwellenwert für den Schutzleiterwiderstand definiert wird, ab dem die Schutzleiterüberwachungseinrichtung 1 eine Schutzleiterstörung erkennt. Insbesondere liegt im in der Figur 2 gezeigten Beispiel die Summe der Widerstandswerte R15 und R9 2,2 kOhm unter dem Widerstandswert von R6. Das bedeutet, dass die Schutzleiterüberwachungseinrichtung 1 ungefähr ab einem Widerstand von 2,2 kOhm zwischen dem Anschlusspunkt 3 und der Erdung 6 des Schutzleiters ein Signal ausgibt, das eine Schutzleiterstörung indiziert. Über die Wahl der Widerstandswerte der Spannungsteiler lässt sich somit die Empfindlichkeit der Schutzleiterüberwachungseinrichtung 1 genau einstellen.

Wie in den Figuren 2, 3 und 4 gezeigt, kann zwischen dem ersten Anschlusspunkt 3 bzw. AP und dem ersten Spannungsteiler ferner eine Diode D5 vorgesehen sein. Diese Diode ist vorzugsweise vom selben Typ wie die Diode D3 der Gleichrichterbrücke und sorgt dafür, dass die unteren Anschlusspunkte der Spannungsteiler ungefähr gleiche Potentiale aufweisen, wenn der Widerstand auf dem Schutzleiter vernachlässigbar ist und die Erdung des Schutzleiters ungefähr das gleiche Potential aufweist wie der Neutralleiter.

Das Messpotential MP und das Vergleichspotential VP werden jeweiligen Eingängen des Komparators 16 zugeführt. Wie in den Figuren 2, 3 und 4 beispielhaft gezeigt, kann der Komparator 16 als Differenzverstärker ausgebildet sein, der die Transistoren Q1 und Q2 und die Widerstände R8, R5 und R6 umfasst. Anstelle der Lastwiderstände R5 und R6 kann auch ein Stromspiegel vorgesehen sein, der den Strom aus dem Kollektor des Transistors Q2 zu dem Kollektor des Transistors Q1 spiegelt. Die Transistoren Q1 und Q2 sind vorzugsweise als PNP-Transistoren ausgebildet.

Der Komparator 16 gibt an seinem Ausgang das Komparatorsignal KS aus. Im in der Figur 3 gezeigten Beispiel ist dieses Komparatorsignal KS am Ausgang P5 des Differenzverstärkers abgreifbar. Wenn das am Knoten P9 anliegende Messpotential MP über dem am Knoten P7 anliegende Vergleichspotential VP liegt, nimmt der Ausgang P5 des Differenzverstärkers einen niedrigen Spannungspegel an. Liegt das Messpotential unter dem Vergleichspotential, so nimmt der Ausgang P5 einen hohen Spannungspegel an.

Das am Ausgang P5 des Differenzverstärkers abgreifbare Komparatorsignal KS wird dem Speicherglied 17 zugeführt. In dem in den Figuren 2, 3 und 4 gezeigten Beispiel umfasst das Speicherglied 17 den Transistor Q3, den Widerstand R13, den Kondensator C1 und vorzugsweise den Widerstand R12. Der Transistor Q3 ist vorzugsweise als NPN-Transistor ausgebildet. Die Basis des Transistors Q3 ist mit dem Ausgang P5 bzw. KS des Differenzverstärkers über einen Widerstand R12 verbunden.

Solange das Potential des Knotens P9 unter dem des Knotens P7 liegt, ist die Spannung am Ausgang des Differenzverstärkers hoch genug um den Transistor Q3 leitend zu schalten. Der Kondensator C1 wird somit in diesem Zustand über den Transistor Q3 entladen. Wenn nun das Potential des Knotens P9 das Potential des Knotens P7 überschreitet, so gibt der Differenzverstärker an seinem Ausgang P5 eine Spannung aus, die niedrig genug ist, um den Transistor Q3 zu sperren. In diesem Zustand beginnt der Kondensator C1, sich über den Widerstand R13 aufzuladen.

Der Ladezustand des Kondensators C1 bzw. die am Kondensator anliegende Spannung dient als das Erkennungssignal ES zur Erkennung einer Schutzleiterstörung. Dies hat den Vorteil, dass ein zeitweises Kippen des Komparators 16 bzw. des Differenzverstärkers, das nicht von einer Schutzleiterstörung verursacht wird, gewissermaßen herausgefiltert wird.

Ein solches zeitweises Kippen des Komparators 16 kann regelmäßig in jeder Periode der von dem Phasenleiter 8 zugeführten Wechselspannung vorkommen.

Das am unteren Ausgangsanschluss 15 der Gleichrichteranordnung 11 anliegende Potential bewegt sich nämlich während einer Periode ungefähr zwischen dem Potential des Neutralleiters 10 und dem in Bezug auf dieses Potential negativsten Wert der vom Phasenleiter 8 zugeführten Wechselspannung. Entsprechend kann das Vergleichspotential VP unter das Potential des Neutralleiters 10 gezogen werden. Im Gegensatz dazu kann das Messpotential MP während einer Periode der Wechselspannung nur bis auf das Potential der Erdung 6 des Schutzleiters PE heruntergezogen werden, das in der Regel dem Potential des Neutralleiters 10 entspricht. Damit ergibt sich während jeder Periode der Wechselspannung zeitweise die Situation, dass das Vergleichspotential VP kleiner ist als das Messpotential MP; d.h., dass das Messpotential MP das Vergleichspotential VP überschreitet, auch wenn keine Schutzleiterstörung vorliegt.

Das Speicherglied 17 ist nun so dimensioniert, das dieses zeitweise Kippen des Komparators während einer Periode der vom Phasenleiter 8 geführten Wechselspannung nicht dazu ausreicht, um den Kondensator so weit aufzuladen, dass das mit dem Speicherglied 17 verbundene erste Schaltglied geschaltet wird. In den in den Figuren 2, 3 und 4 gezeigten Schaltungsbeispielen ist das erste Schaltglied 21 als Transistor Q4 ausgebildet. Der Transistor Q4 ist vorzugsweise ein NPN-Transistor. Der Kondensator C1 und der Widerstand R13 sind nun so ausgelegt, dass das periodische Kippen des Differenzverstärkers bzw. das periodische Sperren des Transistors Q3 nicht ausreicht, um den Kondensator C1 während einer Periode soweit aufzuladen, dass der Transistor Q4 leitend geschaltet wird.

Sofern keine Schutzleiterstörung vorliegt, bewegt sich das Messpotential MP bzw. der Knoten P9 wenigstens einmal pro Periode der vom Phasenleiter 8 geführten Wechselspannung unter das Vergleichspotential VP bzw. den Knoten P7. Dementsprechend wird das Speicherglied 17 bzw. der Kondensator C1, mindestens einmal pro Periode entladen, sofern keine Schutzleiterstörung vorliegt.

Liegt nun eine Schutzleiterstörung vor, so entfällt dieser regelmäßige Entladevorgang des Speicherglieds 17 bzw. des Kondensators C1, und das Speicherglieds 17 bzw. der Kondensators C1 wird bis über die Schaltspannung des ersten Schaltglieds 21 bzw. des Transistors Q4 aufgeladen. Dies kann über mehrere Perioden der vom Phasenleiter 8 geführten Wechselspannung erfolgen.

Wird das erste Schaltglied 21 schließlich leitend geschaltet, so werden das Signalglied 18 und/oder das zweite Schaltglied 19 und/oder das Entkopplungsglied 20 betätigt.

In den in den Figuren 2, 3 und 4 gezeigten Schaltungsbeispielen wird das Signalglied von einer Leuchtdiode D7 und/oder einem Summer bzw. Lautsprecher R4 gebildet. Zusätzlich oder anstelle des Summers R4 kann auch ein Relais bzw. das in der Figur 1 gezeigte zweite Schaltglied 19 vorgesehen sein, das dazu dient, bei Betätigung durch das erste Schaltglied 21 zu bewirken, dass die Verbindung zwischen der elektrischen Leitung 2 und einem oder mehreren an der Stromverteilervorrichtung angeschlossenen elektrischen Verbrauchern getrennt wird.

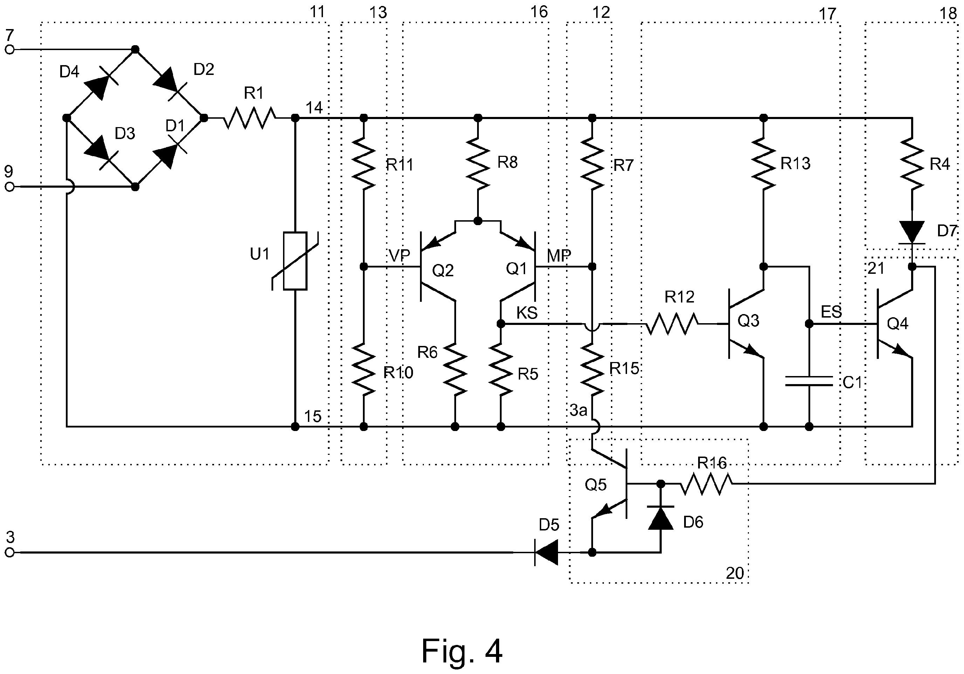

Wie in der Figur 3 oder 4 gezeigt, kann das Entkopplungsglied als Transistor, vorzugsweise als NPN-Transistor Q5 ausgebildet sein. Wenn der Transistor Q4 bzw. das erste Schaltglied 21 leitend geschaltet wird, sperrt das Entkopplungsglied 20 bzw. der Transistor Q5. Somit wird vermieden, dass bei einer Schutzleiterstörung Spannungen in den Schutzleiter 4 eingekoppelt werden.

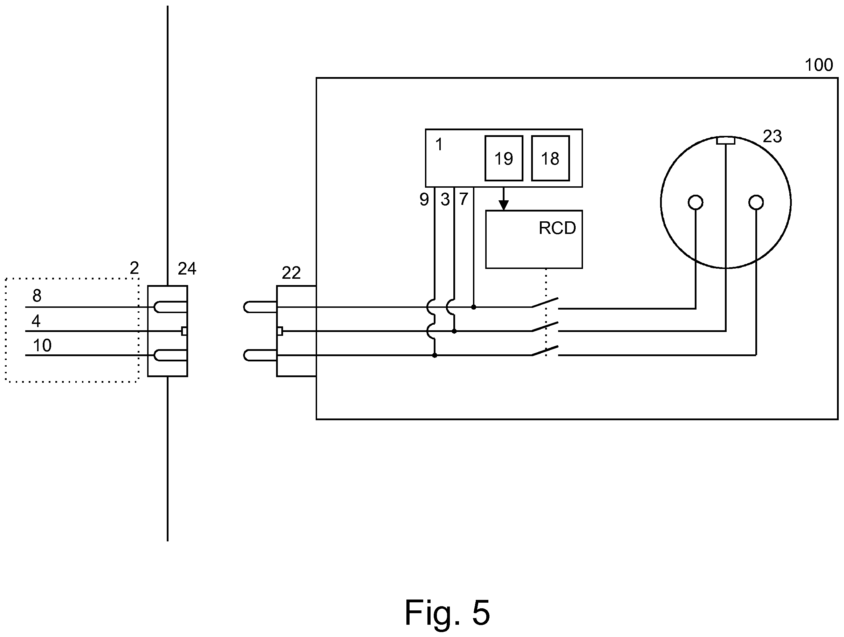

Die Figur 5 zeigt eine schematische Darstellung einer beispielhaften Stromverteilervorrichtung 100. Im hier gezeigten Beispiel ist die Stromverteilervorrichtung 100 als ortsveränderliche Stromverteilervorrichtung dargestellt. Alternativ dazu kann die Stromverteilervorrichtung 100 auch ortsfest ausgebildet sein. Beispielsweise können die in der Figur 5 gezeigte Steckdose 23 und der Netzstecker 22 als feste Anschlussterminals einer ortsfesten Stromverteilervorrichtung ausgeführt sein. Die nachstehende Beschreibung bezieht sich deshalb in Analogie auch auf den Fall, dass die Stromverteilervorrichtung ortsveränderlich ausgebildet ist.

Wie in der Figur 5 gezeigt, umfasst die Stromverteilervorrichtung 100 die vorstehend beschriebene Schutzleiterüberwachungseinrichtung 1, einen Netzstecker 22, einen FehlerstromSchutzschalter RCD und eine Steckdose 23. Die Schutzleiterüberwachungseinrichtung 1 umfasst hier zumindest die eingangs beschriebenen erfindungsgemäßen Merkmale und insbesondere ein als LED oder Lautsprecher ausgebildetes Signalglied 18 und/oder ein zweites Schaltglied 19 der vorstehend beschriebenen Art.

Die Stromverteilervorrichtung kann anhand des Netzsteckers 22 in die fest installierte Steckdose 24 gesteckt werden, um mit der elektrischen Leitung 2 elektrisch verbunden zu werden und über die Steckdose 23 einem elektrischen Verbraucher die von der elektrischen Leitung 2 bereitgestellte Netzspannung zuzuführen. Die Schutzleiterüberwachungseinrichtung umfasst die Anschlusspunkte 3, 7 und 9, die mit den Kontakten des Netzsteckers verbunden sind und so ebenfalls eine elektrische Verbindung mit dem Phasenleiter 7, dem Neutralleiter 9 und dem Schutzleiter 4 der elektrischen Leitung 2 eingehen können.

In einem Zustand, in dem die Stromverteilervorrichtung 100 elektrisch mit der elektrischen Leitung 2 verbunden ist, überwacht die Schutzleiterüberwachungseinrichtung 1 den Widerstand zwischen dem ersten Anschlusspunkt 3 und der Erdung des Schutzleiters 4. Falls der überwachte Widerstand einen vorbestimmten Schwellenwert überschreitet, gibt die Schutzleiterüberwachungsvorrichtung 1 über das Signalglied 18 ein optisches und/oder akustisches Warnsignal aus. Ferner bewirkt die Schutzleiterüberwachungsvorrichtung 1 über den Fehlerstrom-Schutzschalter RCD, dass die Steckdose 23 von der elektrischen Leitung 2 getrennt wird.

In bevorzugter Weise ist der Fehlerstromschutzschalter, RCD, als DI-Schalter oder FI-Schalter ausgebildet sein. Der Fehlerstromschutzschalter kann von dem zweiten Schaltglied 19 betätigt werden, um im Falle einer Schutzleiterstörung an der Stromverteilervorrichtung angeschlossene elektrische Verbraucher von der elektrischen Leitung zu trennen.

Zusätzlich zu der Schutzleiterüberwachungseinrichtung 1 kann die Stromverteilervorrichtung ein (nicht gezeigtes) Phasenüberwachungsmodul aufweisen, das ausgebildet ist, vorzugsweise anhand einer kapazitiven Phasenfelderkennung, zu detektieren, dass der Schutzleiter 4 eine Wechselspannung führt, und in diesem Fall zu bewirken, dass eine elektrische Verbindung zwischen einem elektrischen Verbraucher und dem Phasenleiter 8, dem Neutralleiter 10 und/oder dem Schutzleiter 4 getrennt wird. Insbesondere kann hierfür das in der DE 10 2013 017 252 A1 beschriebene Überwachungsmodul oder eine diesem Modul ähnliche Einrichtung verwendet werden.

In der vorstehenden Beschreibung umfasst die elektrische Leitung 2 mindestens einen Phasenleiter 8. Die elektrische Leitung 2 kann auch mehrere Phasenleiter 8 umfassen. Insbesondere kann die elektrische Leitung 2 drei Phasenleiter umfassen. Entsprechend kann das zweite Schaltglied 19 ausgebildet sein, eine Trennung eines elektrischen Verbrauchers von allen Phasenleitern der elektrischen Leitung 2 zu bewirken.

Die im Folgenden beschriebene Ausführungsform steht mit dem in der Figur 2 gezeigten Beispiel einer Schutzleiterüberwachungseinrichtung im Zusammenhang und betrifft vorzugsweise eine universelle Netzüberwachung mit PRCD-S Funktion.

Die Ausführungsform betrifft ferner eine permanent prüfende Schutzeinrichtung für Netzstromanschlüsse bei fehlendem Schutzleiter. Bei Erkennen der fehlenden PE-Erdung warnt diese per optischem und/oder akustischem Ton.

Die Ausführungsform betrifft ferner eine Universalelektronik zur Schutzleiterüberwachung. Diese erkennt Fehler schon im niederohmigen Bereich durch eine weitere Stufe von Hochvolttransistoren 2N3439, die als Differenzverstärker geschaltet sind.

Die Schutzleiterüberwachungsvorrichtung kann daher geringste Änderungen des Schutzleiterwiderstandes und somit eine Verschlechterung der Erdverbindung detektieren. Die Detektierung des Schutzleiterwiderstandes ist empfindlicher als bisher und als der bekannte Stand der Technik dies vermag.

Die Ausführungsform betrifft weiterhin eine Erkennung eines unter Spannung stehenden Schutzleiters und warnt ebenfalls optisch und/oder akustisch.

Als allgemeiner Stand der Technik dient ein herkömmlicher Stromkreis, der mit einem FI-Schutzschalter überwacht wird und nicht erkennen kann, ob ein Schutzleiter vorliegt.

Hier wird der Benutzer weder gewarnt noch geschützt, ob alles in Ordnung ist bzw. ob an der primär angezapften genutzten Versorgungs-Steckdose der Schutzleiter ankommt, da der Nutzer des Stromkreises dies sonst nur durch Messung erkennen kann.

Diese entwickelte Schutzeinrichtung, prüft und überwacht, schon primär zu (1) die davor genutzte vielleicht defekte Steckdose am Arbeitsplatz, im Büro oder auf der Baustelle über die Steckverbindung des Steckers.

Der Netzfehler wird durch eine rotes LED auffällig angezeigt mit der Aufschrift Achtung: Lebensgefahr Schutzleiter unterbrochen.

Der Ton wird mit einem Piezopieper lautstark zu erkennen gegeben.

Zusätzlich kann diese Sicherheitstechnik auch durch Relais abschalten.

Die Technik ist insoweit eine Weiterentwicklung, welche wesentlich empfindlicher ist als die bisherigen und zusätzlich warnt, wenn der "PE" Netzphase führt.

Ein Prüftaster gibt die Möglichkeit, die Schaltung gelegentlich auf Auslösung zu prüfen. Des Weiteren ist es schaltungsintern leicht möglich, eine Eigenüberwachung zu deren Ausfall zu integrieren.

Die folgenden nummerierten Merkmalskombinationen stehen mit der in der Figur 2 gezeigten beispielhaften Schaltung im Zusammenhang:
Erste Merkmalskombination: Netzüberwachungselektronik (1) die mit einer elektrischen Leitung (2), die mit einen Netzstecker verbunden ist und das vorhanden sein der Schutzerde erkennt, um beim Fehlen dieser Alarm auslöst. Netzüberwachungselektronik mit einem Stecker leitend verbunden in eine Steckdose gesteckt wird die zur Spannungsversorgung zum Beispiel an einem Arbeitsplatz dient.
Zweite Merkmalskombination: Netzüberwachungselektronik (1) dadurch gekennzeichnet, dass diese sich in einem Kleingehäuse befindet, welches in sich 2 elektronische Überwachungssysteme vereinigt, zum einen die "PE" Überwachung, zum anderen die Erkennung ob eventuell Netzphase -Spannung auf dem PE ist.
Dritte Merkmalskombination: Netzüberwachungselektronik (1) dadurch gekennzeichnet, dass die in der Elektronikbox befindliche Schaltung mit in erster Linie Hochvolttransistoren 2N3439 u. div Halbleitern im niederohmigen Bereich den PE detektiert.
Vierte Merkmalskombination: Nach einer der vorhergehenden Merkmalskombinationen, dadurch gekennzeichnet, dass die direkte Wirkung zunächst nur optisch u. akustisch alarmiert.
Fünfte Merkmalskombination: Nach einer der vorhergehenden Merkmalskombinationen dadurch gekennzeichnet, dass auch die Möglichkeit einer Abschaltung gegeben ist, mittels einem zusätzlichen Schaltrelais würde dies erfolgen, welches in anderen Anwendungen einzusetzen möglich wäre. In der Merkmalskombination hier auf einen vorgeschalteten normalen Standard FI-Schalter PRCD/RCD wirkt, welcher die Netztrennung übernimmt.
Siebte Merkmalskombination: Netzüberwachungselektronik dadurch gekennzeichnet, dass diese nicht nur an Arbeitsplatzsteckdosen, Büro und PC-Plätzen sondern auch in Geräten einsetzbar ist und den Benutzer einer Maschine sofort warnt.

Die im Folgenden beschriebene Ausführungsform steht mit dem in der Figur 3 gezeigten Beispiel einer Schutzleiterüberwachungsvorrichtung in Zusammenhang und betrifft vorzugsweise eine universelle Netzüberwachung mit PRCD-S Funktion.

Diese Ausführungsform betrifft ferner eine Technik zur Schutzleiterüberwachung, welche folgende Besonderheiten hat:
Zum einem eine sichere permanente Überwachung zur Erkennung eines schlecht kontaktierten, oder nicht vorhandenen unterbrochenen Schutzleiters, so gelöst, dass dies selbst schon im niederohmigen Bereich detektiert wird.

Mit sehr wenigen Bauteilen in der Hauptsache -5 Hochvolt Transistoren- die in einer Differenzstromschaltung niederohmig den "PE" erkennen, wurde eine auch preiswerte Schaltung konstruiert, die über einen Brückengleichrichter die Schaltung mit pulsierender Gleichspannung versorgt.

Ob im Fehlerfall oder bei Normalbetrieb mit vorhandenem "PE" fließt fast kein Strom im "PE", lediglich im Mikroamperebereich, dennoch erkennt die Schaltung ob die Schutzerde fehlt und reagiert sofort darauf, indem diese nicht nur optisch und/oder akustisch warnt, sondern auch einen RCD ansteuert, der abschaltet.

Bei Fehlen des "PE" erfolgt somit eine Netztrennung über die genutzten Lastkontakte eines RCD/FI, sodass dieser RCD die Funktionalität eines heute bekannten PRCD-S technisch damit darstellt.

Zustände wie fehlender "PE" blockiert die Einschaltung des RCD, bei Unterbrechung durch zwischenzeitlichen Kabelbruch im Betrieb am Stecker oder an der Zuleitung der Versorgungs-steckdose erfolgt sofort die sichere allpolige Abschaltung, einschließlich des "PE".

Die Ausführungsform betrifft eine universelle Netzüberwachungselektronik, welche permanent die Überwachung des Schutzleiters "PE", bzw. das Vorhandensein einer "niederohmigen PE Verbindung" an Netzstromanschlüssen erkennt und bei fehlender Erde, schlechter Kontaktverbindung sowie Spannungsfreiheit sofort sicherheitstechnisch abschaltend reagiert. Es muss zwingend "PE" vorhanden sein.

Bei Erkennen z.B. der fehlenden "PE"-Erdung warnt die Schaltung optisch und/oder akustisch, oder durch eine Abschaltfunktion mittels eines Relais, welches einen RCD FI-Schalter zum Abschalten der Netzspannung mit dessen Lastkontakten bringt.

Die Ausführungsform betrifft eine Schaltung welche den "PE" im niederohmigen Bereich detektieren kann. Bisher bekannte Schaltungen arbeiten im Bereich mehrerer 100 kOhm mit der Erkennung Schutzleiter in Ordnung - vorhanden.

Die Ausführungsform erkennt "PE" Verbindungen durch oxidierte oder schlechte Kontaktübergaben bzw. das Fehlen des "PE".

Durch die Schaltungstechnik mit der Besonderheit der Differenzstromverstärkung wurde die so umgesetzt, so dass schon geringe Übergangswiderstände des Schutzleiterkontaktes z.B. bei Korrosion oder schlechter Kontaktübergabe in einer Steckdose erkannt werden, um abschalttechnisch zu reagieren.

Die Überwachungselektronik sollte beim Einsatz in Kabeltrommeln mit einem FI-Schalter gekoppelt sein, welcher dann mit dessen Lastkontakten eine allpolige Abschaltung (incl. PE) eine sogenannte PRCD-S Funktionalität übernimmt.

Diese elektronische Schaltung erkennt im niederohmigen Bereich mit dessen 5 Hochvolttransistoren z.B. 2N3439 NPN und 2N5416 PNP als Differenzverstärker geschaltet schon geringe Änderungen des Schutzleiterwiderstandes, somit eine Verschlechterung der Erdverbindung. Daraus folgt eine hoch empfindliche Detektierung des Schutzleiterwiderstandes als bisherige Schaltungstechniken dies so vermögen. Hochvolttransistoren welche sicher mit diesen hohen Spannungen arbeiten, sind deshalb hier einzusetzen.

Die Ausführungsform betrifft weiterhin eine Erkennung eines unter Spannung stehenden Schutzleiters und warnt ebenfalls optisch und akustisch, bzw. schaltet ab.

Diese Schutzeinrichtung prüft und überwacht somit primär zu (1) die davor genutzte vielleicht defekte Steckdose am Arbeitsplatz, im Büro oder auf der Baustelle vom Versorgungspunkt über die Steckverbindung des Steckers.

Ein zusätzlicher Prüftaster gäbe die Möglichkeit, die Schaltung gelegentlich auf Auslösung zu prüfen.

Schaltungstechnisch ist es ebenfalls möglich eine Eigenüberwachung für deren Funktionsausfall zu integrieren.

Im Folgenden wird ein beispielhaftes Funktionsprinzip der in der Figur 3 gezeigten beispielhaften Schaltung erklärt.

V1 symbolisiert die Anschlüsse der 230V Netzspannung.

V1 steuert eine Brückengleichrichterschaltung bestehend aus den Dioden D1 bis D4 an.

Am Punkt "Brückengleichrichter Plus" liegt der positive Pol der damit erzeugten pulsierenden Gleichspannung, am Punkt "Brückengleichrichter Minus" der negative Pol. Die pulsierende Gleichspannung dient zur Stromversorgung der restlichen Schaltung.

Die restliche Schaltung bestromt die LED D7 (Alarmzustand), wenn der Punkt AP (entspricht dem PE Anschluss) hochohmig oder gar nicht mit Erdpotential verbunden ist. Die LED leuchtet dann und zeigt damit dem Anwender den Fehlzustand an.

R4 kann einen Summer darstellen, oder ein Microrelais welches einen RCD mit einem Vorwiderstand brückt, sodass dieser mit seinen Kontakten Netz abschaltet.

Im anderen Fall wird die LED nicht bestromt und bleibt dunkel (Ruhezustand), der Summer gibt keinen Alarmton ab, ein Relais hier würde nicht ansprechen.

Bei vollkommen erdfreien AP Potential hält die Sperrstrecke von Q5 unerwünschte, hochohmige Einkopplungen der Phase vom PE Kontakt fern.

Im Folgenden wird der Ruhezustand (LED D7 unbestromt) beschrieben. Im Ruhezustand ist AP niederohmig mit Erdpotential verbunden. Die Basis von Q5 wird über die LED D7 bestromt, Q5 schaltet durch. Dadurch wird der Differenzverstärkereingang P9 unter das Potential von P7 gesenkt, Q1 schaltet durch und bestromt die Basis von Q3. Q3 schaltet durch und sperrt somit Q4.

Dadurch wird LED D7 (bis auf einen sehr geringen Dunkelstrom zur Ansteuerung der Basis von Q5) stromlos gehalten und verbleibt im nicht leuchtenden Zustand.

Im Folgenden wird der Alarmzustand (LED D7 bestromt) beschrieben. Etabliert sich zwischen AP und dem Erdpotential ein entsprechender Widerstand, wird der Differenzverstärkereingang P9 über das Potential von P7 gehoben, Q2 leitet und Q1 sperrt, die Basis von Q3 wird damit stromlos geschaltet. Die Basis von Q4 wird über R13 bestromt und Q4 öffnet. Damit wird die LED D7 mit Strom beschickt, leuchtet und zeigt damit den Alarmzustand an. Durch Veränderung des ohmschen Widerstandes R15 kann man die Empfindlichkeit des Ansprechverhaltens festlegen um im Bereich von ca. 50-100 Ohm zu detektieren.

Setzt man an Stelle des R4 ein Mikrorelais, welches den Eingang und Ausgang des RCD - FI-Schalter über einen 5kOhm/50mA Widerstand vom Phaseneingang zum Nullausgang also eine Diagonalbrücke, löst dieser bei fehlendem "PE" sofort aus.

Die technisch preiswerte Lösung mit langlebigen Bauteilen ohne Elkos, Transformatoren oder hochempfindliche IC-Schaltkreise stellt eine langlebige, sichere Überwachung des Schutzleiters dar. Entgegen bekannter Schaltungen fließt auf Grund der Schaltung so gut wie kein Strom im "PE".

Die folgenden nummerierten Merkmalskombinationen stehen mit der in Figur 3 gezeigten beispielhaften Schaltung im Zusammenhang:
Erste Merkmalskombination: Universal Netzüberwachungselektronik (1) z.B. in einem Leitungskabelroller integriert verbaut. Mit einem Netzstecker und dessen elektrischer Zuleitung. Der integrierte Steckdosenverteiler erhält nur Strom, wenn kein Fehler vorliegt. Die Netzüberwachungselektronik (1) erkennt das Fehlen der Erdung / PE Schutzleiter und im Fehlerfall reagiert diese sicherheitstechnisch sofort.
Zweite Merkmalskombination: Nach der vorhergehenden Merkmalskombination Netzüberwachungselektronik (1) dadurch gekennzeichnet, dass diese sich in einem kleinen isolierten Kunststoffgehäuse befindet, welches in sich 2 elektronische Systeme vereinigt. Zum einem wenn der "PE" unterbrochen ist oder fehlt, zum anderen falls dieser gegen Erde Spannung führt, also als "PE" nicht wie vorgeschrieben vorhanden ist.
Dritte Merkmalskombination: Schutzleiterüberwachungselektronik (1) dadurch gekennzeichnet dass die in dem Gehäuse befindliche Elektronikschaltung über einen Brückengleichrichter 5 Hochvolttransistoren versorgt, sodass diese Schaltung sehr sensibel den "PE" bei zwar vorhanden, bei nicht korrekt kontaktiert als schlecht erkennt. Die Schaltung ist ohne Elektrolytkondensatoren dauerhaft und sicher aufgebaut. Die Auswertung des Erkennens einer schlechten Kontaktübergabe an Klemmschrauben oder oxidierten Schutzkontakten hat somit eine sofortige Abschaltung zur Folge oder sperren schon das Einschalten.
Vierte Merkmalskombination: Nach einer der vorhergehenden Merkmalskombinationen dadurch gekennzeichnet, dass die Fehlererkennung nicht nur eine optische u. akustische Meldung ausgibt, sondern einen RCD - Schalter / Fehlerstromschutzschalter mit einem Microrelais ansteuern u. auslösen kann. Der Fehlerstromschalter RCD (5) sollte sich neben der Elektronik (1) befinden, weil diese elektrisch damit verbunden ist.
Fünfte Merkmalskombination: Nach der vorhergehenden Merkmalskombination dadurch gekennzeichnet, dass durch die Abschaltung des RCD über ein Mikrorelais in der Elektronik (1) erfolgt weil der RCD damit angesteuert wird und die Lastkontakte eines RCD zur Netztrennung genutzt werden. Das Zusammenspiel der Technik hat eine sogenannte PRCD-S Funktionalität mit neuartiger niederohmiger "PE" Kennung.
Sechste Merkmalskombination: Nach der ersten Merkmalskombination, dadurch gekennzeichnet, dass die Netzüberwachungselektronik sowohl innerhalb einer Kabeltrommel, in einem Stromverteiler oder auch direkt hinter dem Netzstecker des Zuleitungskabels mittels einem PRCD - Schalter in einem schlagfesten Gummigehäuse in Kombination mit diesem hier integriert ist, um die Erkennung und sofortig Sicherheitsauslösung hier zu übernehmen. Auch in Maschinen aus Metall die nach VDE zwingend notwendig geerdet sein müssen, wie Waschmaschinen, Trockner, Betonmischer, Aufzüge an Gerüsten auf Baustellen etc. kann diese elektronische "PE" Schutzleiterüberwachung mit optischem oder akustischem Alarm sowie mit Auslösung direkt integriert sein.

## Patentansprüche

1. Stromverteilervorrichtung (100), die ortsfest oder ortsveränderlich ausgebildet ist, insbesondere Steckdose, Steckdosenleiste, Steckadapter, Leitungsroller, Baustromverteiler, Anschlussleitung oder Verlängerungsleitung, die dazu dient, einem oder mehreren elektrischen Verbrauchern eine Netzspannung bereitzustellen, die von einer mit einem Schutzleiter (4) ausgestatteten elektrischen Leitung (2) zugeführt wird, mit einer Schutzleiterüberwachungseinrichtung (1) zur Erkennung einer Schutzleiterstörung auf der elektrischen Leitung (2), wobei die Schutzleiterüberwachungseinrichtung (1) einen ersten Anschlusspunkt (3) umfasst, der mit dem Schutzleiter (4) elektrisch verbindbar oder verbunden ist, wobei die Schutzleiterüberwachungseinrichtung (1) ferner umfasst: eine erste Schaltungsanordnung (12), die ausgebildet ist, in einem Zustand, in dem der erste Anschlusspunkt (3) mit dem Schutzleiter (4) verbunden ist, ein Messpotential (MP) bereitzustellen, das von dem Widerstand zwischen dem ersten Anschlusspunkt (3) und der Erdung (6) des Schutzleiters (4) abhängt, eine zweite Schaltungsanordnung (13), die ausgebildet ist, ein Vergleichspotential (VP) bereitzustellen, eine einen Komparator (16) aufweisende Komparatoranordnung (5), die ausgebildet ist, das Messpotential (MP) mit dem Vergleichspotential (VP) zu vergleichen und gemäß dem Vergleichsergebnis ein Erkennungssignal (ES) zur Erkennung einer Schutzleiterstörung bereitzustellen, einen zweiten Anschlusspunkt (7), der mit einem Phasenleiter (8) der elektrischen Leitung (2) elektrisch verbindbar oder verbunden ist, einen dritten Anschlusspunkt (9), der mit einem Neutralleiter (10) der elektrischen Leitung (2) elektrisch verbindbar oder verbunden ist, und eine vorzugsweise mit einer Gleichrichterbrücke ausgestattete Gleichrichteranordnung (11), die ausgebildet ist, eine zwischen dem zweiten Anschlusspunkt (7) und dem dritten Anschlusspunkt (9) anliegende Wechselspannung in eine gleichgerichtete Spannung zu wandeln und diese der Komparatoranordnung (5) über den Ausgang der Gleichrichteranordnung (11) als Versorgungsspannung zuzuführen, wobei die erste Schaltungsanordnung (12) ausgebildet ist, das Messpotential (MP) von einer Spannung abzuleiten, die zwischen einem Ausgangsanschluss (14) der Gleichrichteranordnung (11) und einem mit dem ersten Anschlusspunkt (3) elektrisch verbundenen Knoten (3a) anliegt, und das Messpotential (MP) der Komparatoranordnung (5) bereitzustellen, und die zweite Schaltungsanordnung (13) ausgebildet ist, das Vergleichspotential (VP) von der zwischen den beiden Ausgangsanschlüssen (14, 15) der Gleichrichteranordnung (11) anliegenden gleichgerichteten Spannung abzuleiten und der Komparatoranordnung (5) bereitzustellen.

2. Stromverteilervorrichtung (100) nach Anspruch 1, **dadurch gekennzeichnet, dass** der Komparator (16) einen Differenzverstärker umfasst und die erste Schaltungsanordnung (12) und die zweite Schaltungsanordnung (13) ausgebildet sind, das Messpotential (MP) und das Vergleichspotential (VP) den Eingängen des Differenzverstärkers zuzuführen.

3. Stromverteilervorrichtung (100) nach Anspruch 1 oder 2 **dadurch gekennzeichnet, dass** die erste Schaltungsanordnung (12) einen ersten Spannungsteiler mit vorzugsweise wenigstens zwei Widerständen umfasst, wobei der erste Spannungsteiler zwischen dem Ausgangsanschluss der Gleichrichteranordnung (11) und dem mit dem ersten Anschlusspunkt (3) elektrisch verbundenen Knoten (3a) geschaltet ist und ausgebildet ist, die über dem ersten Spannungsteiler anliegende Spannung in einem ersten vorbestimmten Verhältnis aufzuteilen und das resultierende Potential der Komparatoranordnung (5) als das Messpotential (MP) bereitzustellen.

4. Stromverteilervorrichtung (100) nach einem der voranstehenden Ansprüche, **dadurch gekennzeichnet, dass** die zweite Schaltungsanordnung (13) einen zweiten Spannungsteiler mit vorzugsweise wenigstens zwei Widerständen umfasst, wobei der zweite Spannungsteiler zwischen beiden Ausgangsanschlüssen (14, 15) der Gleichrichteranordnung (11) geschaltet ist und ausgebildet ist, die gleichgerichtete Spannung in einem zweiten vorbestimmten Verhältnis aufzuteilen und das resultierende Potential der Komparatoranordnung (5) als das Vergleichspotential (VP) bereitzustellen.

5. Stromverteilervorrichtung (100) nach einem der voranstehenden Ansprüche, **dadurch gekennzeichnet, dass** die Komparatoranordnung (5) ferner ein Speicherglied (17), vorzugsweise ein Tiefpassglied, umfasst, der Komparator (16) ausgebildet ist, das Messpotential (MP) mit dem Vergleichspotential (VP) zu vergleichen und gemäß dem Vergleichsergebnis ein Komparatorsignal (KS) auszugeben, die Komparatoranordnung ausgebildet ist, das Speicherglied (17) gemäß dem Komparatorsignal (KS) aufzuladen oder zu entladen, und das Erkennungssignal (ES) gemäß dem Ladezustand des Speicherglieds (17) bereitzustellen, wobei das Speicherglied (17) vorzugsweise einen Kondensator umfasst und das Erkennungssignal (ES) vorzugsweise von der über dem Kondensator abfallenden Spannung abhängt.

6. Stromverteilervorrichtung (100) nach einem der voranstehenden Ansprüche, **dadurch gekennzeichnet, dass** die Schutzleiterüberwachungseinrichtung (1) ferner umfasst: wenigstens ein vorzugsweise eine LED und/oder einen Lautsprecher aufweisendes Signalglied (18), das ausgebildet ist, bei Betätigung ein elektrisches, optisches und/oder akustisches Signal zur Anzeige einer Schutzleiterstörung auszugeben, und ein erstes Schaltglied (21), das ausgebildet ist, das Signalglied (18) zu betätigen, falls das Erkennungssignal (ES) einen vorbestimmten Schwellenwert überschreitet oder unterschreitet.

7. Stromverteilervorrichtung (100) nach einem der voranstehenden Ansprüche, **dadurch gekennzeichnet, dass** die Schutzleiterüberwachungseinrichtung (1) ferner umfasst: ein vorzugsweise ein Relais aufweisendes zweites Schaltglied (19) zur Ansteuerung einer Fehlerstrom-Schutzeinrichtung (RCD), das ausgebildet ist, bei Betätigung zu bewirken, dass eine elektrische Verbindung zwischen dem einen oder mehreren elektrischen Verbrauchern und dem Phasenleiter (8), dem Neutralleiter (10) und/oder dem Schutzleiter (4) getrennt wird, und ein erstes Schaltglied (21), das ausgebildet ist, das zweite Schaltglied (19) zu betätigen, falls das Erkennungssignal (ES) einen vorbestimmten Schwellenwert überschreitet oder unterschreitet.

8. Stromverteilervorrichtung (100) nach einem der voranstehenden Ansprüche, **dadurch gekennzeichnet, dass** die Schutzleiterüberwachungseinrichtung (1) ferner umfasst: ein vorzugsweise mit einem Transistor ausgestattetes Entkopplungsglied (20), das ausgebildet ist, bei Betätigung die elektrische Verbindung zwischen der ersten Schaltungsanordnung (12) und dem ersten Anschlusspunkt (3) hochohmig zu schalten, und ein erstes Schaltglied (21), das ausgebildet ist, das Entkopplungsglied (20) zu betätigen, falls das Erkennungssignal (ES) einen vorbestimmten Schwellenwert überschreitet oder unterschreitet.

9. Stromverteilervorrichtung (100) nach einem der voranstehenden Ansprüche, **dadurch gekennzeichnet, dass** die Schutzleiterüberwachungseinrichtung (1) ferner umfasst: ein Phasenüberwachungsmodul, das ausgebildet ist, vorzugsweise anhand einer kapazitiven Phasenfelderkennung, zu detektieren, dass der Schutzleiter (4) eine Wechselspannung führt, und in diesem Fall zu bewirken, dass eine elektrische Verbindung zwischen einem elektrischen Verbraucher und dem Phasenleiter (8), dem Neutralleiter (10) und/oder dem Schutzleiter (4) getrennt wird.

10. Stromverteilervorrichtung (100) nach einem der voranstehenden Ansprüche, **gekennzeichnet durch** einen Netzstecker (22), wobei der erste Anschlusspunkt (3), der zweite Anschlusspunkt (7) und der dritte Anschlusspunkt (9) mit jeweiligen Kontakten des Netzsteckers elektrisch verbunden sind.

11. Schutzleiterüberwachungsverfahren zur Erkennung, mittels einer Stromverteilervorrichtung (100) gemäß einem der voranstehenden Ansprüche, einer Schutzleiterstörung auf einer mit einem Schutzleiter (4) ausgestatteten elektrischen Leitung (2), **gekennzeichnet durch** die Schritte: Bereitstellen, durch die erste Schaltungsanordnung (12), eines Messpotentials (MP), das von dem Widerstand zwischen dem mit dem Schutzleiter (4) der elektrischen Leitung (2) verbundenen ersten Anschlusspunkt (3) und der Erdung (6) der elektrischen Leitung (2) abhängt, Bereitstellen, durch die zweite Schaltungsanordnung (13), eines Vergleichspotentials (VP), Vergleichen, durch die Komparatoranordnung (5), des Messpotentials (MP) mit dem Vergleichspotential (VP), und Ausgeben, gemäß dem Vergleichsergebnis, eines Erkennungssignals (ES) zur Erkennung einer Schutzleiterstörung.

## Claims

1. Current distribution device (100), which is adapted to be stationary or movable, in particular socket, socket strip, plug adapter, cable reel, construction current distributor, connecting cable or extension cable, which serves to provide one or more electrical consumers with a mains voltage which is supplied by an electrical line (2) equipped with a protective conductor (4), with a protective conductor monitoring device (1) for detecting a protective conductor fault on the electrical line (2), the protective conductor monitoring device (1) comprising a first connection point (3) which can be electrically connected or is connected to the protective conductor (4), the protective conductor monitoring device (1) further comprising: a first circuit arrangement (12) adapted, to provide, in a state in which the first connection point (3) is connected to the protective conductor (4), a measurement potential (MP) dependent on the resistance between the first connection point (3) and the ground (6) of the protective conductor (4), a second circuit arrangement (13) adapted to provide a comparison potential (VP), a comparator arrangement (5) having a comparator (16), which comparator arrangement (5) is adapted to compare the measurement potential (MP) with the comparison potential (VP) and to provide, in accordance with the comparison result, a detection signal (ES) for detecting a protective conductor fault, a second connection point (7), which can be electrically connected or is connected to a phase conductor (8) of the electrical line (2), a third connection point (9), which can be electrically connected or is electrically connected to a neutral conductor (10) of the electrical line (2), and a rectifier arrangement (11) which is preferably equipped with a rectifier bridge and which is adapted to convert an alternating voltage present between the second connection point (7) and the third connection point (9) into a rectified voltage and to supply this to the comparator arrangement (5) as supply voltage via the output of the rectifier arrangement (11), the first circuit arrangement (12) being adapted to derive the measurement potential (MP) from a voltage, which is present between an output terminal (14) of the rectifier arrangement (11) and a node (3a) electrically connected to the first connection point (3), and to provide the measurement potential (MP) to the comparator arrangement (5), and the second circuit arrangement (13) is adapted to derive the comparison potential (VP) from the rectified voltage present between the two output terminals (14, 15) of the rectifier arrangement (11) and to provide it to the comparator arrangement (5).

2. Current distribution device (100) according to claim 1, **characterized in that** the comparator (16) comprises a differential amplifier, and the first circuit arrangement (12) and the second circuit arrangement (13) are adapted to supply the measurement potential (MP) and the comparison potential (VP) to the inputs of the differential amplifier.

3. Current distribution device (100) according to claim 1 or 2, **characterized in that** the first circuit arrangement (12) comprises a first voltage divider with preferably at least two resistors, the first voltage divider being connected between the output terminal of the rectifier arrangement (11) and the node (3a) electrically connected to the first connection point (3), and being adapted to divide the voltage present across the first voltage divider in a first predetermined ratio and to provide the resulting potential to the comparator arrangement (5) as the measurement potential (MP).

4. Current distribution device (100) according to one of the preceding claims, **characterized in that** the second circuit arrangement (13) comprises a second voltage divider with preferably at least two resistors, the second voltage divider being connected between both output terminals (14, 15) of the rectifier arrangement (11) and being adapted to divide the rectified voltage in a second predetermined ratio and to provide the resulting potential to the comparator arrangement (5) as the comparison potential (VP).

5. Current distribution device (100) according to one of the preceding claims, **characterized in that** the comparator arrangement (5) further comprises a memory element (17), preferably a low-pass element, the comparator (16) is adapted to compare the measurement potential (MP) with the comparison potential (VP) and to output a comparator signal (KS) according to the comparison result, the comparator arrangement is adapted to charge or discharge the memory element (17) according to the comparator signal (KS) and to provide the detection signal (ES) according to the charge level of the memory element (17), wherein the memory element (17) preferably comprises a capacitor and the detection signal (ES) preferably depends on the voltage across the capacitor.

6. Current distribution device (100) according to one of the preceding claims, **characterized in that** the protective conductor monitoring device (1) further comprises: at least one signal element (18), preferably comprising an LED and/or a loudspeaker, adapted to output, upon actuation, an electrical, optical and/or acoustic signal for indicating a protective conductor fault, and a first switching element (21) adapted to actuate the signal element (18) if the detection signal (ES) exceeds or falls below a predetermined threshold.

7. Current distribution apparatus (100) according to one of the preceding claims, **characterized in that** the protective conductor monitoring device (1) further comprises: a second switching element (19), preferably having a relay, for controlling a fault current protection device (RCD), said second switching element (19) being adapted to cause, upon actuation, an electrical connection between said one or more electrical consumers and said phase conductor (8), said neutral conductor (10) and/or said protective conductor (4) to be disconnected, and a first switching element (21) adapted to actuate said second switching element (19) if said detection signal (ES) exceeds or falls below a predetermined threshold.

8. Current distribution apparatus (100) according to one of the preceding claims, **characterized in that** the protective conductor monitoring device (1) further comprises: a decoupling element (20) preferably provided with a transistor, said decoupling element (20) being adapted to switch, upon actuation, the electrical connection between the first circuit arrangement (12) and the first connection point (3) to high impedance, and a first switching element (21) adapted to actuate the decoupling element (20) if the detection signal (ES) exceeds or falls below a predetermined threshold.

9. Current distribution device (100) according to one of the preceding claims, **characterized in that** the protective conductor monitoring device (1) further comprises: a phase monitoring module adapted to detect, preferably by means of capacitive phase field detection, that the protective conductor (4) carries an alternating voltage, and in this case to cause an electrical connection between an electrical consumer and the phase conductor (8), the neutral conductor (10) and/or the protective conductor (4) to be disconnected.

10. Current distribution device (100) according to one of the preceding claims, **characterized by** a power plug (22), wherein the first connection point (3), the second connection point (7) and the third connection point (9) are electrically connected to respective contacts of the power plug.

11. Protective conductor monitoring method for detecting, by means of a current distribution device (100) in accordance with one of the preceding claims, a protective conductor fault on an electrical line (2) equipped with a protective conductor (4), **characterized by** the steps: providing, by the first circuit arrangement (12), a measurement potential (MP) depending on the resistance between the first connection point (3) connected to the protective conductor (4) of the electrical line (2) and the ground (6) of the electrical line (2), providing, by the second circuit arrangement (13), a comparison potential (VP), comparing, by the comparator arrangement (5), the measurement potential (MP) with the comparison potential (VP), and outputting, in accordance with the comparison result, a detection signal (ES) for detecting a protective conductor fault.

## Revendications

1. Dispositif de répartition de l'alimentation (100), conçu de manière fixe ou mobile, en particulier prise, bloc multiprise, adaptateur, enrouleur de câble, armoire électrique de chantier, câble de raccordement ou rallonge, qui sert à fournir à un ou plusieurs consommateurs électriques une tension secteur qui est acheminée par un câble électrique (2) équipé d'un conducteur de protection (4), avec un dispositif de surveillance de conducteur de protection (1) pour détecter un défaut de conducteur de protection sur le câble électrique (2), dans lequel le dispositif de surveillance de conducteur de protection (1) comprend un premier point de raccordement (3) qui peut être relié ou est relié électriquement au conducteur de protection (4), dans lequel le dispositif de surveillance de conducteur de protection (1) comprend en outre : un premier circuit (12), qui est conçu pour, dans un état dans lequel le premier point de raccordement (3) est relié au conducteur de protection (4), fournir un potentiel de mesure (MP) qui dépend de la résistance entre le premier point de raccordement (3) et la terre (6) du conducteur de protection (4), un second circuit (13), qui est conçu pour fournir un potentiel de comparaison (VP), un circuit comparateur (5) comprenant un comparateur (16), qui est conçu pour comparer le potentiel de mesure (MP) au potentiel de comparaison (VP) et fournir en fonction du résultat de la comparaison un signal de détection (ES) pour détecter un défaut de conducteur de protection, un deuxième point de raccordement (7) qui peut être relié ou est relié électriquement à un conducteur de phase (8) du câble électrique (2), un troisième point de raccordement (9) qui peut être relié ou est relié électriquement à un conducteur neutre (10) du câble électrique (2), et un ensemble redresseur (11) équipé de préférence d'un pont redresseur, qui est conçu pour transformer une tension alternative présente entre le deuxième point de raccordement (7) et le troisième point de raccordement (9) en une tension redressée et l'acheminer en tant que tension d'alimentation au circuit comparateur (5) via la sortie de l'ensemble redresseur (11), dans lequel le premier circuit (12) est conçu pour dériver le potentiel de mesure (MP) d'une tension qui est présente entre une borne de sortie (14) de l'ensemble redresseur (11) et un nœud (3a) relié électriquement au premier point de raccordement (3), et fournir le potentiel de mesure (MP) au circuit comparateur (5), et le second circuit (13) est conçu pour dériver le potentiel de comparaison (VP) de la tension redressée présente entre les deux bornes de sortie (14, 15) de l'ensemble redresseur (11) et pour le fournir au circuit comparateur (5).

2. Dispositif de répartition de l'alimentation (100) selon la revendication 1, **caractérisé en ce que** le comparateur (16) comprend un amplificateur différentiel et le premier circuit (12) et le second circuit (13) sont conçus pour acheminer le potentiel de mesure (MP) et le potentiel de comparaison (VP) aux entrées de l'amplificateur différentiel.

3. Dispositif de répartition de l'alimentation (100) selon la revendication 1 ou 2, **caractérisé en ce que** le premier circuit (12) comprend un premier diviseur de tension avec de préférence au moins deux résistances, dans lequel le premier diviseur de tension est monté entre la borne de sortie de l'ensemble redresseur (11) et le nœud (3a) relié électriquement au premier point de raccordement (3) et est conçu pour diviser la tension présente via le premier diviseur de tension en un premier rapport prédéterminé et pour fournir le potentiel résultant au circuit comparateur (5) en tant que potentiel de mesure (MP).

4. Dispositif de répartition de l'alimentation (100) selon l'une des revendications précédentes, **caractérisé en ce que** le second circuit (13) comprend un second diviseur de tension avec de préférence au moins deux résistances, dans lequel le second diviseur de tension est monté entre les deux bornes de sortie (14, 15) de l'ensemble redresseur (11) et est conçu pour diviser la tension redressée en un deuxième rapport prédéterminé et fournir le potentiel résultant au circuit comparateur (5) en tant que potentiel de comparaison (VP).

5. Dispositif de répartition de l'alimentation (100) selon l'une des revendications précédentes, **caractérisé en ce que** le circuit comparateur (5) comprend en outre un élément de mémoire (17), de préférence un élément passe-bas, le comparateur (16) est conçu pour comparer le potentiel de mesure (MP) au potentiel de comparaison (VP) et pour délivrer un signal de comparateur (KS) en fonction du résultat de la comparaison, le circuit comparateur est conçu pour charger ou décharger l'élément de mémoire (17) en fonction du signal de comparateur (KS), et pour fournir le signal de détection (ES) en fonction de l'état de charge de l'élément de mémoire (17), dans lequel l'élément de mémoire (17) comprend de préférence un condensateur et le signal de détection (ES) dépend de préférence de la tension qui chute via le condensateur.

6. Dispositif de répartition de l'alimentation (100) selon l'une des revendications précédentes, **caractérisé en ce que** le dispositif de surveillance de conducteur de protection (1) comprend en outre : au moins un élément de signalisation (18) comprenant de préférence une LED et/ou un haut-parleur, qui est conçu pour, lorsqu'il est activé, délivrer un signal électrique, optique et/ou acoustique pour indiquer un défaut de conducteur de protection, et un premier élément de commutation (21) qui est conçu pour activer l'élément de signalisation (18) dans le cas où le signal de détection (ES) dépasse ou tombe sous une valeur seuil prédéterminée.

7. Dispositif de répartition de l'alimentation (100) selon l'une des revendications précédentes, **caractérisé en ce que** le dispositif de surveillance de conducteur de protection (1) comprend en outre : un second élément de commutation (19), comprenant de préférence un relais, pour commander un dispositif de protection contre les courants de défaut (RCD), qui est conçu pour, lorsqu'il est activé, faire en sorte que soit interrompue une liaison électrique entre les un ou plusieurs consommateurs électriques et le conducteur de phase (8), le conducteur neutre (10) et/ou le conducteur de protection (4), et un premier élément de commutation (21) qui est conçu pour activer le second élément de commutation (19) dans le cas où le signal de détection (ES) dépasse ou tombe sous une valeur seuil prédéterminée.

8. Dispositif de répartition de l'alimentation (100) selon l'une des revendications précédentes, **caractérisé en ce que** le dispositif de surveillance de conducteur de protection (1) comprend en outre : un élément de découplage (20), équipé de préférence d'un transistor, qui est conçu pour, lorsqu'il est activé, commuter à une impédance élevée la liaison électrique entre le premier circuit (12) et le premier point de raccordement (3), et un premier élément de commutation (21) qui est conçu pour activer l'élément de découplage (20) dans le cas où le signal de détection (ES) dépasse ou tombe sous une valeur seuil prédéterminée.

9. Dispositif de répartition de l'alimentation (100) selon l'une des revendications précédentes, **caractérisé en ce que** le dispositif de surveillance de conducteur de protection (1) comprend en outre : un module de surveillance de phase qui est conçu pour détecter, de préférence à l'aide d'une détection capacitive de champ de phase, que le conducteur de protection (4) est parcouru par une tension alternative, et pour, dans ce cas, faire en sorte que soit interrompue une liaison électrique entre un consommateur électrique et le conducteur de phase (8), le conducteur neutre (10) et/ou le conducteur de protection (4).

10. Dispositif de répartition de l'alimentation (100) selon l'une des revendications précédentes, **caractérisé par** une fiche secteur (22), dans lequel le premier point de raccordement (3), le deuxième point de raccordement (7) et le troisième point de raccordement (9) sont reliés électriquement aux contacts respectifs de la fiche secteur.

11. Procédé de surveillance de conducteur de protection pour détecter, au moyen d'un dispositif de répartition de l'alimentation (100) selon l'une des revendications précédentes, un défaut de conducteur de protection sur un câble électrique (2) équipé d'un conducteur de protection (4), **caractérisé par** les étapes suivantes : fourniture, par le premier circuit (12), d'un potentiel de mesure (MP) qui dépend de la résistance entre le premier point de raccordement (3) relié au conducteur de protection (4) du câble électrique (2) et la terre (6) du câble électrique (2), fourniture, par le second circuit (13), d'un potentiel de comparaison (VP), comparaison, par le circuit comparateur (5), du potentiel de mesure (MP) avec le potentiel de comparaison (VP), et délivrance, en fonction du résultat de la comparaison, d'un signal de détection (ES) pour détecter un défaut de conducteur de protection.
